# FASCICULE DE BREVET EUROPEEN

(11) **EP 3 289 521 B1**
(45) Date de publication et mention de la délivrance du brevet: **17.07.2019**
(21) Numéro de dépôt: 16726127.0
(22) Date de dépôt: 27.04.2016
(51) Int. Cl.: G06K 9/00

(54) **CAPTEUR D'EMPREINTES DIGITALES OU PALMAIRES**
FINGERABDRUCK- ODER HANDFLÄCHENSENSOR
FINGERPRINT OR PALMPRINT SENSOR

(30) Priorité: 30.04.2015 FR 1553921
(43) Date de publication de la demande: 07.03.2018
(73) Titulaire: Commissariat à l'énergie atomique et aux énergies alternatives, 75015 Paris (FR); Idemia Identity & Security France, 92400 Courbevoie (FR)
(72) Inventeur: MAINGUET, Jean-François, 38100 Grenoble (FR); FOURRE, Joel Yann, 78160 Marly-le-roi (FR); SEGURA PUCHADES, Josep, 38600 Fontaine (FR)
(74) Mandataire: Cabinet Beaumont
(86) Numéro de dépôt international: PCT/FR2016/050992
(87) Numéro de publication internationale: WO 2016/174353

(56) Documents cités:
- WO-A1-2015/008902
- US-A1- 2003 090 650
- US-A1- 2014 354 597

## Description

La présente demande de brevet revendique la priorité de la demande de brevet français FR15/53921 qui sera considérée comme faisant partie intégrante de la présente description.

### Domaine

La présente demande concerne les capteurs d'empreintes digitales ou palmaires, et, plus généralement, les capteurs d'empreintes de portions de peau.

### Exposé de l'art antérieur

Divers types de capteurs ont été proposés pour réaliser une acquisition électronique d'une empreinte digitale et/ou palmaire, c'est-à-dire pour fournir une image du motif formé par les crêtes et vallées (ou creux) de la peau d'un doigt, de plusieurs doigts, et/ou de la paume de la main. On a notamment proposé des capteurs optiques, des capteurs capacitifs, des capteurs thermiques, des capteurs à ultrasons, et des capteurs à champ électrique. WO2015/008902 divulgue de tels capteurs.

On s'intéresse notamment ici aux capteurs d'empreintes capacitifs, thermiques et/ou optiques réalisés en technologie TFT (de l'anglais "Thin Film Transistor" - transistor en couches minces), c'est-à-dire comportant, sur un substrat de support diélectrique, une ou plusieurs cellules élémentaires d'acquisition, chaque cellule élémentaire (ou pixel) comportant un élément d'acquisition photoélectrique, pyroélectrique et/ou capacitif, et un ou plusieurs transistors TFT permettant de commander cet élément. Par transistor TFT, on entend ici des transistors formés par dépôts successifs de couches conductrices, isolantes et semiconductrices sur le substrat de support. En particulier, dans un transistor TFT, la région semiconductrice de formation de canal du transistor est réalisée par dépôt d'une couche d'un matériau semiconducteur, par exemple du silicium amorphe hydrogéné, du silicium polycristallin (rendu polycristallin après un recuit par exemple), ou encore un matériau de type IGZO (de l'anglais "Indium Gallium Zinc Oxyde" - oxyde d'indium gallium zinc), ce dépôt pouvant être précédé ou suivi d'un dépôt d'une couche conductrice servant à former une électrode de grille, de source ou de drain du transistor. Les capteurs d'empreintes réalisés en technologie TFT présentent l'avantage d'être relativement peu onéreux, notamment grâce à l'utilisation d'un substrat de support en un matériau à faible coût tel que le verre (au lieu d'un substrat en silicium monocristallin généralement utilisé pour réaliser des transistors), et d'être facilement intégrables dans de nombreux types de dispositifs électroniques, et en particulier dans des dispositifs utilisant déjà la technologie TFT pour réaliser d'autres fonctions, par exemple pour réaliser des écrans d'affichage. La technologie TFT est tout particulièrement avantageuse dans le domaine des capteurs d'empreintes dans lesquels la surface du capteur est sensiblement identique à la surface de l'empreinte à acquérir, c'est-à-dire dans lesquels aucun système optique de focalisation (ou objectif) n'est placé entre le capteur et l'objet dont on souhaite acquérir une image. En effet, de tels capteurs ont généralement des surfaces relativement importantes, notamment lorsque l'empreinte à acquérir porte sur plusieurs doigts et/ou sur la paume de la main, et tirent donc avantage du faible prix de revient de la technologie TFT. Des modes de réalisation seront décrits ci-après en relation avec des exemples illustratifs d'implémentation en technologie TFT. Les modes de réalisation décrits ne se limitent toutefois pas à la technologie TFT.

Il serait souhaitable de pouvoir améliorer au moins certains aspects des capteurs d'empreintes thermiques, optiques et/ou capacitifs existants.

### Résumé

Pour cela, un mode de réalisation prévoit un capteur d'empreintes comportant, sur un substrat de support, une pluralité de cellules élémentaires d'acquisition, chaque cellule comportant : un noeud de lecture ; un premier élément de conversion photoélectrique ou pyroélectrique ayant une première électrode connectée au noeud de lecture et une deuxième électrode connectée à un noeud de commande de la cellule ; et une troisième électrode connectée au noeud de lecture, la troisième électrode étant revêtue d'une couche diélectrique et étant destinée à former une capacité avec la peau d'un utilisateur, dans lequel, dans chaque cellule, le noeud de commande est adapté à recevoir un signal de commande permettant la mise en oeuvre d'une lecture, sur le noeud de lecture, d'une valeur représentative de la capacité formée entre la troisième électrode et la peau de l'utilisateur.

Selon un mode de réalisation, dans chaque cellule, le premier élément est un élément de conversion photoélectrique.

Selon un mode de réalisation, dans chaque cellule, le premier élément est une photodiode dont l'anode est connectée au noeud de commande et dont la cathode est connectée au noeud de lecture.

Selon un mode de réalisation, chaque cellule comprend en outre un élément de conversion pyroélectrique connecté entre le noeud de commande et le noeud de lecture, en parallèle du premier élément.

Selon un mode de réalisation, dans chaque cellule, le premier élément est un élément de conversion pyroélectrique.

Selon un mode de réalisation, chaque cellule comprend en outre un élément de conversion photoélectrique relié au noeud de lecture par l'intermédiaire d'un transistor de sélection.

Selon un mode de réalisation, le signal de commande est un créneau de tension.

Selon un mode de réalisation, le capteur comprend en outre une source lumineuse et/ou une source de chaleur.

Selon un mode de réalisation, dans chaque cellule, le noeud de lecture est relié à un noeud d'application d'un potentiel de réinitialisation par l'intermédiaire d'un transistor de réinitialisation.

Selon un mode de réalisation, dans chaque cellule, le noeud de lecture est relié à une piste de sortie de la cellule par l'intermédiaire d'un transistor monté en source suiveuse et d'un transistor de lecture.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 est un schéma électrique illustrant un exemple d'un capteur d'empreintes TFT optique ;
la figure 2 est un schéma électrique illustrant un exemple d'un capteur d'empreintes TFT thermique ;
la figure 3 est un schéma électrique illustrant un exemple d'un capteur d'empreintes TFT capacitif ;
la figure 4 est un schéma électrique illustrant un exemple d'un mode de réalisation d'un capteur d'empreintes TFT thermique et capacitif ;
la figure 5 est une vue en coupe illustrant un exemple de réalisation du capteur de la figure 4 ;
la figure 6 est un schéma électrique illustrant un exemple d'un mode de réalisation d'un capteur d'empreintes TFT optique et capacitif ;
la figure 7 est un schéma électrique illustrant un exemple d'un mode de réalisation d'un capteur d'empreintes TFT optique, thermique et capacitif ; et
la figure 8 est un schéma électrique illustrant une variante de réalisation du capteur de la figure 7.

### Description détaillée

Par souci de clarté, de mêmes éléments ont été désignés par de mêmes références aux différentes figures. De plus, seuls les éléments utiles à la compréhension des modes de réalisation décrits ont été détaillés. En particulier, les circuits périphériques de commande des cellules élémentaires des capteurs d'empreintes TFT décrits n'ont pas été détaillés, la réalisation de tels circuits étant à la portée de l'homme de l'art à la lecture de la présente description. On notera par ailleurs que dans la présente description, lorsque des architectures de cellules élémentaires, de matrices de cellules élémentaires ou de capteurs d'empreintes sont décrites, on utilise le terme "connecté" pour désigner une liaison électrique directe, sans composant électronique intermédiaire, par exemple au moyen d'une piste conductrice, et le terme "couplé" ou le terme "relié", pour désigner une liaison électrique directe ou via un ou plusieurs composants intermédiaires, par exemple via un transistor. En outre, dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures.

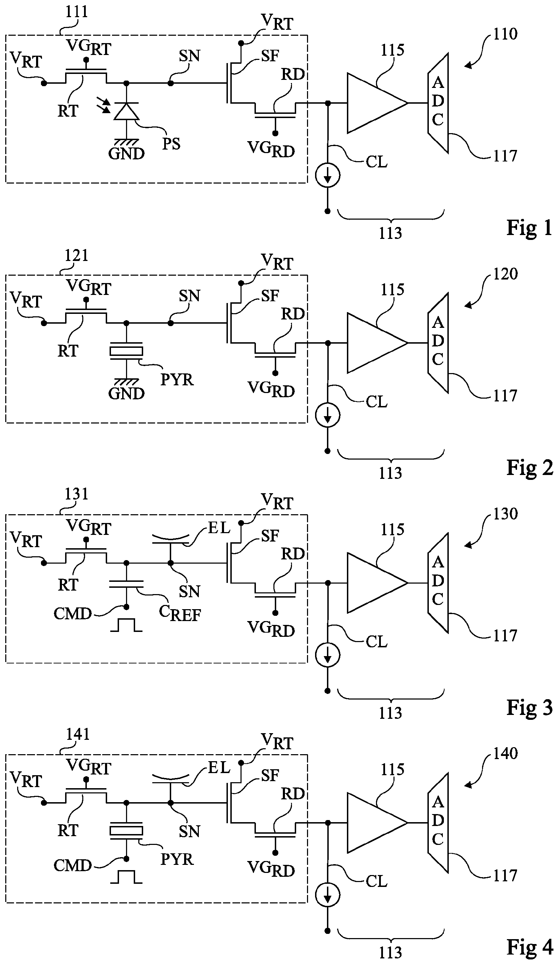

La figure 1 est un schéma électrique illustrant un exemple d'un capteur d'empreintes TFT optique 110. Le capteur 110 comprend une pluralité de cellules élémentaires d'acquisition 111 identiques ou similaires, réalisées en technologie TFT sur une face d'un substrat de support transparent, par exemple en verre, que l'on appellera ci-après par convention la face supérieure du substrat. Par souci de simplification, une seule cellule 111 a été représentée sur la figure 1. Chaque cellule 111 comprend un élément de conversion photoélectrique PS, par exemple une photodiode dont l'anode est reliée à un noeud d'application d'un potentiel de référence GND (par exemple la masse), et dont la cathode est connectée à un noeud capacitif de lecture SN de la cellule. A titre d'exemple, le photodétecteur PS est une photodiode, par exemple de type PIN, PN ou organique, ou tout autre élément photosensible tel qu'un phototransistor ou un élément à base de SRO (de l'anglais "Silicon Rich Oxyde" - oxyde enrichi au silicium). En pratique, la capacité du noeud SN comprend la capacité parasite du photodétecteur PS, à laquelle s'additionnent les capacités parasites d'un ou plusieurs transistors de la cellule connectés au noeud SN. Dans cet exemple (usuellement appelé pixel actif à trois transistors), chaque cellule 111 comprend un transistor de réinitialisation RT reliant son noeud de lecture SN à un noeud d'application d'un potentiel de réinitialisation V_{RT}, par exemple un potentiel positif par rapport au potentiel du noeud GND. Chaque cellule 111 comprend en outre un transistor SF monté en source suiveuse, dont la grille est connectée au noeud SN, et un transistor de lecture RD reliant la source du transistor SF à une piste de sortie CL de la cellule. Le drain du transistor SF est relié à un noeud d'application d'un potentiel de référence, par exemple le potentiel V_{RT} ou un autre potentiel. La grille de commande du transistor RT est connectée à un noeud VG_{RT} d'application d'un potentiel de commande de ce transistor, et la grille du transistor RD est connectée à un noeud VG_{RD} d'application d'un potentiel de commande de ce transistor.

La piste de sortie CL de la cellule 111 est connectée à un étage de sortie 113 du capteur. Dans cet exemple, l'étage de sortie 113 comprend un amplificateur 115 dont une entrée est reliée à la piste CL et dont la sortie est reliée à un convertisseur analogique-numérique 117 (ADC). L'amplificateur 115 est optionnel, et peut notamment être omis si le niveau de potentiel de la piste CL est compatible avec l'entrée du convertisseur analogique-numérique 117.

Le capteur 110 comprend en outre une source lumineuse d'éclairage, non représentée. A titre d'exemple, la source d'éclairage est disposée du côté de la face du substrat opposée aux cellules 111, que l'on appellera ci-après par convention la face inférieure du substrat.

Le fonctionnement du capteur 110 est le suivant. L'utilisateur place un doigt (ou plusieurs et/ou la paume) sur ou au-dessus de la surface supérieure du capteur (côté cellules 111) . La source lumineuse de rétroéclairage, disposée du côté du substrat opposé aux cellules, éclaire le doigt à travers des zones transparentes de l'ensemble formé par le substrat de support et les cellules 111. La lumière est alors rétrodiffusée par le doigt en direction des photodétecteurs PS, avec, au niveau de chaque cellule 111, une atténuation plus ou moins importante selon que la portion de doigt située au-dessus de la cellule correspond à une crête ou à une vallée (ou un creux) de la peau du doigt. A titre de variante, la source lumineuse peut être placée au-dessus ou à côté du doigt, la lumière étant alors transmise par le doigt en direction des photodétecteurs PS du capteur, avec une atténuation plus ou moins importante selon que la portion de doigt située au-dessus de la cellule correspond à une crête ou à une vallée de la peau du doigt. Dans ce dernier mode de réalisation, on choisit par exemple un éclairage rouge ou infrarouge de façon que la quantité de lumière transmise à travers le doigt soit importante.

Lors d'une phase d'acquisition d'un point d'image d'une empreinte par une cellule 111, le photodétecteur PS de la cellule est d'abord réinitialisé par l'intermédiaire du transistor RT de la cellule. Le transistor RT est ensuite rendu non passant, et, pendant une période d'intégration, des charges photogénérées (généralement négatives) s'accumulent sur le noeud de lecture SN de la cellule. A la fin de l'intégration, le potentiel du noeud de lecture SN est reporté sur la piste de sortie CL de la cellule par l'intermédiaire des transistors SF et RD. Pour cela, le transistor RD de la cellule est rendu passant. Le potentiel de la piste de sortie CL est alors lu par l'étage de sortie 113 associé à la piste de sortie CL. A titre d'exemple, le potentiel du noeud de lecture peut aussi être lu après la réinitialisation et avant le début de l'intégration, la valeur de sortie du pixel étant alors la différence entre la valeur de référence lue avant l'intégration et la valeur lue après l'intégration.

A titre d'exemple, plusieurs cellules élémentaires 111 peuvent être connectées à une même piste de sortie CL et partager un même étage de sortie 113 du capteur. Les cellules 111 sont par exemple disposées en matrice selon des lignes et des colonnes, les cellules d'une même colonne étant connectées à une même piste de sortie CL et à un même étage de sortie 113, et les cellules de colonnes distinctes étant connectées à des pistes de sortie CL distinctes et à des étages de sortie 113 distincts. A titre d'exemple, les cellules 111 sont commandables simultanément ligne par ligne, c'est-à-dire que les cellules 111 d'une même ligne ont leurs noeuds VG_{RT}, respectivement VG_{RD}, connectés à une même piste de commande et les cellules 111 de lignes distinctes ont leurs noeuds VG_{RT}, respectivement VG_{RD}, connectés à des pistes de commande distinctes.

La figure 2 est un schéma électrique illustrant un exemple d'un capteur d'empreintes TFT thermique 120. Le capteur 120 de la figure 2 comprend des éléments communs avec le capteur 110 de la figure 1. Ces éléments ne seront pas décrits à nouveau. Le capteur 120 diffère du capteur 110 principalement en ce que, dans le capteur 120, des cellules élémentaires d'acquisition 121 de type thermique remplacent les cellules élémentaires d'acquisition optiques 111 du capteur 110. Les cellules élémentaires 121 du capteur de la figure 2 diffèrent des cellules élémentaires 111 du capteur de la figure 1 en ce que, dans chaque cellule 121, un élément de conversion pyroélectrique PYR, reliant le noeud de lecture SN de la cellule au noeud GND, remplace le photodétecteur PS des cellules 111. L'élément de conversion pyroélectrique PYR comprend typiquement une couche d'un matériau pyroélectrique tel que le nitrure d'aluminium (AIN), l'oxyde de zinc (ZnO), un polymère tel que le polyfluorure de vinylidène (PVDF), dont le coefficient pyroélectrique est de l'ordre de 40 µC/m²/K, un matériau céramique de type PZT (titanozirconate de plomb), dont le coefficient pyroélectrique est de l'ordre de 350 µC/m²/K, ou un matériau cristallin de type TGS (Triglycine sulfate) ou LiTaO₃, disposée entre deux couches conductrices (électrodes) connectées respectivement au noeud SN et au noeud GND.

Le capteur 120 diffère en outre du capteur 110 de la figure 1 en ce qu'il ne comprend pas de source lumineuse de rétroéclairage, mais comprend une source de chaleur, non représentée. A titre d'exemple la source de chaleur peut comprendre un réseau de résistances régulièrement réparties sur la surface du capteur. A titre d'exemple, la source de chaleur comprend une résistance par cellule élémentaire, cette résistance étant disposée au voisinage de l'élément pyroélectrique de la cellule. Les résistances de la source de chaleur sont de préférence disposées du même côté du substrat de support que les cellules 121, c'est-à-dire du côté de la face supérieure du substrat.

Le fonctionnement du capteur 120 est le suivant. L'utilisateur ayant placé un doigt (ou plusieurs) sur ou au-dessus de la surface supérieure du capteur (côté cellules 121), la source de chaleur du capteur est mise en marche, et chauffe les éléments de conversion pyroélectrique PYR qui génèrent en conséquence des charges électriques sur les noeuds de lecture SN des cellules 121 correspondantes. La quantité de chaleur reçue par chaque élément de conversion pyroélectrique PYR lorsque la source de chaleur est allumée est plus importante lorsque la cellule correspondante est surmontée par une vallée de la peau, que lorsqu'elle est surmontée par une crête. En effet, lorsque la cellule est surmontée par une crête, la peau (qui est un relativement bon conducteur thermique) absorbe une part plus importante de la chaleur émise par la source que lorsque la cellule est surmontée par une vallée. Ainsi, lorsqu'une cellule est surmontée par une vallée de la peau, la quantité de charges électriques générées sur son noeud de lecture SN est plus importante que lorsque la cellule est surmontée par une crête.

Lors d'une phase d'acquisition d'un point d'image d'une empreinte par une cellule 121, le noeud de lecture SN de la cellule est d'abord réinitialisé par l'intermédiaire du transistor RT. Pendant une période d'intégration (transistor RT bloqué), des charges générées par l'élément de conversion pyroélectrique PYR s'accumulent sur le noeud de lecture SN de la cellule. A la fin de l'intégration, le potentiel du noeud de lecture SN est reporté sur la piste de sortie CL de la cellule par l'intermédiaire des transistors SF et RD. Pour cela, le transistor RD de la cellule est rendu passant. Le potentiel de la piste de sortie CL est alors lu par l'étage de sortie 113 associé à la piste de sortie CL. A titre d'exemple, le potentiel du noeud de lecture peut aussi être lu après la réinitialisation et avant le début de l'intégration, la valeur de sortie du pixel étant alors la différence entre la valeur de référence lue avant l'intégration et la valeur lue après l'intégration.

De préférence, lors d'une acquisition, la source de chaleur est commandée pour produire une impulsion de chaleur, et les cellules sont lues un certain temps après le début de l'impulsion, et/ou peu de temps après la fin de cette impulsion, de façon à s'affranchir des phénomènes de thermalisation entraînant, avec le temps, l'uniformisation des niveaux de charge accumulés sur les noeuds de lecture SN des différentes cellules.

Comme dans l'exemple de la figure 1, plusieurs cellules élémentaires 121 peuvent être connectées à une même piste de sortie CL et partager un même étage de sortie 113 du capteur. Les cellules 121 sont par exemple disposées en matrice selon des lignes et des colonnes, les cellules d'une même colonne étant connectées à une même piste de sortie CL et à un même étage de sortie 113, et les cellules de colonnes distinctes étant connectées à des pistes de sortie CL distinctes et à des étages de sortie 113 distincts. A titre d'exemple, les cellules 121 sont commandables simultanément ligne par ligne. De préférence, la source de chaleur est alors commandable pour chauffer les cellules 121 ligne par ligne. Ceci permet de réaliser un balayage du capteur ligne par ligne en synchronisant l'allumage de la source de chaleur avec la lecture des cellules, et ainsi de minimiser les effets de la thermalisation sur l'image acquise. Dans ce cas, la source de chaleur peut être constituée par des pistes conductrices s'étendant le long des lignes du capteur, par exemple des pistes en métal (par exemple en molybdène ou en aluminium), des pistes en un oxyde métallique, éventuellement transparent (par exemple en oxyde d'indium étain ou indium zinc), des pistes en silicium polycristallin, ou des pistes en un polymère conducteur.

La figure 3 est un schéma électrique illustrant un exemple d'un capteur d'empreintes TFT capacitif 130. Le capteur 130 comprend des éléments communs avec les capteurs 110 et 120 des figures 1 et 2. Ces éléments ne seront pas décrits à nouveau ci-après. Le capteur 130 diffère des capteurs 110 et 120 des figures 1 et 2 essentiellement en ce que, dans le capteur 130, des cellules élémentaires d'acquisition 131 de type capacitif remplacent les cellules d'acquisition optiques ou thermiques des capteurs 110 et 120. Dans cet exemple, le capteur 130 ne comprend pas de source lumineuse d'éclairage ni de source de chaleur. Chaque cellule 131 comprend les mêmes éléments qu'une cellule 111 ou 121 des capteurs des figures 1 et 2, à l'exception de l'élément de conversion optique PS ou pyroélectrique PYR. Chaque cellule 131 comprend en outre un condensateur de référence C_{REF}, connecté entre le noeud de lecture SN de la cellule et un noeud CMD d'application d'un signal de commande. Chaque cellule 131 comprend de plus une électrode conductrice EL connectée au noeud SN, l'électrode EL étant revêtue d'une couche diélectrique et étant destinée à former une capacité avec la peau d'un doigt de l'utilisateur. L'électrode EL est de préférence placée au voisinage de la surface supérieure du capteur, de façon que l'épaisseur de diélectrique entre la surface supérieure du capteur (destinée à recevoir le doigt de l'utilisateur) et l'électrode EL ne dépasse pas quelques microns, par exemple 10 µm.

Le fonctionnement du capteur 130 est le suivant. L'utilisateur place un doigt (ou plusieurs) sur ou au-dessus de la surface supérieure du capteur (côté électrodes EL). Lors de l'acquisition d'un point d'image de l'empreinte par une cellule 131, le noeud de lecture SN de la cellule est d'abord réinitialisé par l'intermédiaire du transistor RT de la cellule. Le transistor RT est ensuite rendu non passant, puis un signal de commande, par exemple une tension en créneau ou échelon, est appliqué sur le noeud de commande CMD de la cellule par un circuit de commande non représenté. Une valeur de référence peut être lue sur le noeud SN après la réinitialisation et avant l'application du créneau de tension. La capacité de référence C_{REF} et la capacité formée entre l'électrode EL et la peau du doigt forment un pont diviseur capacitif. Un potentiel dépendant de la capacité formée entre l'électrode EL et la peau s'établit alors sur le noeud de lecture SN de la cellule. La valeur de ce potentiel est différente selon que l'électrode EL est surmontée par une crête ou par une vallée de la peau de l'utilisateur (car la capacité formée entre l'électrode EL et la peau est différente selon que l'électrode EL est surmontée par une crête ou par une vallée de la peau) . Le potentiel du noeud SN est reporté sur la piste de sortie CL de la cellule par l'intermédiaire des transistors SF et RD, puis le potentiel de la piste de sortie CL est lu par l'étage de sortie 113 associé à la piste de sortie CL. L'échelon appliqué sur le noeud CMD peut alors être ramené à sa valeur initiale.

Selon un aspect des modes de réalisation décrits, on prévoit un capteur d'empreintes réalisé en technologie TFT, ce capteur comportant, sur un substrat de support isolant transparent, par exemple en verre, une pluralité de cellules élémentaires d'acquisition, chaque cellule comportant un élément de conversion photoélectrique ou pyroélectrique, permettant d'acquérir une image optique ou thermique d'une empreinte, et un élément de lecture d'une image capacitive de l'empreinte.

Un avantage d'un tel capteur est que les deux images sont acquises au moyen d'éléments d'acquisition basés sur des phénomènes (optique et capacitif, ou thermique et capacitif) n'ayant, à priori, pas de relation physique. Ceci permet de résoudre, dans une certaine mesure, les difficultés rencontrées lors de l'acquisition d'empreintes de doigts dits "difficiles", c'est-à-dire certains types de doigts sur lesquels les capteurs usuels ne parviennent pas à discriminer de façon satisfaisante les crêtes des vallées de la peau. Les inventeurs ont en effet constaté qu'une empreinte difficile à acquérir dans le domaine optique ou thermique est parfois plus facile à acquérir dans le domaine capacitif, et, inversement, qu'une empreinte difficile à acquérir dans le domaine capacitif peut être plus facile à acquérir dans le domaine optique ou thermique.

Le fait d'intégrer l'élément de conversion photoélectrique ou pyroélectrique et l'élément capacitif dans une même cellule élémentaire permet de partager des transistors TFT de commande, et ainsi de limiter l'encombrement, la complexité et le coût du capteur.

Plus particulièrement, chaque cellule comprend, comme dans l'exemple de la figure 3, une électrode revêtue d'une couche diélectrique, destinée à former une capacité avec la peau d'un utilisateur, cette électrode étant connectée au noeud de lecture de la cellule.

Selon un aspect des modes de réalisation décrits, les cellules ne comportent en revanche pas de condensateur de référence spécifique comme dans l'exemple de la figure 3. Dans les modes de réalisation décrits, la capacité de référence utilisée pour la lecture capacitive est celle de l'élément de conversion photoélectrique ou pyroélectrique connecté au noeud de lecture de la cellule. Ceci permet de réaliser des cellules particulièrement compactes.

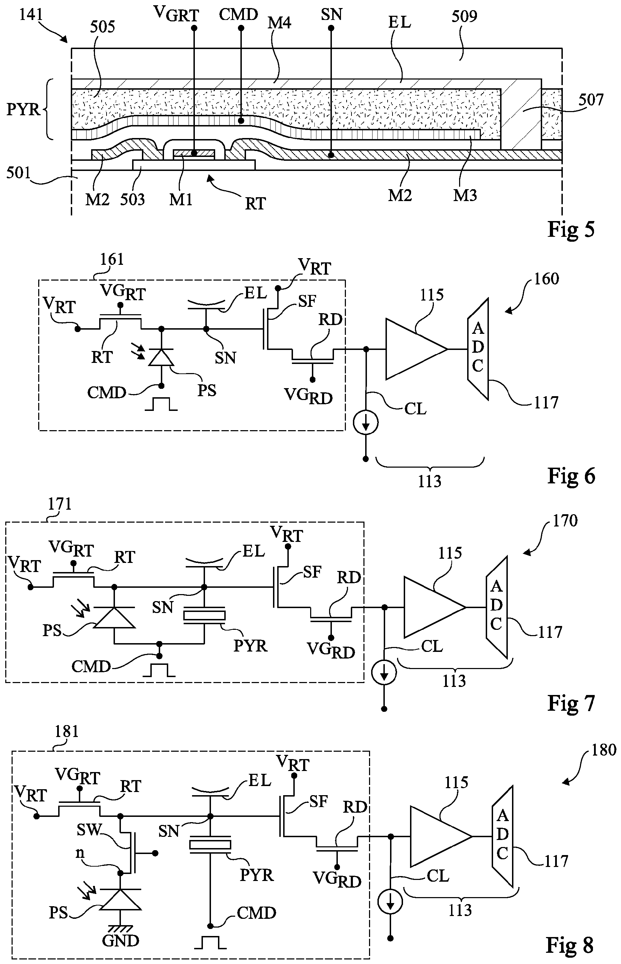

La figure 4 est un schéma électrique illustrant un exemple d'un mode de réalisation d'un capteur d'empreintes TFT thermique et capacitif 140. Le capteur 140 de la figure 4 comprend des éléments communs avec le capteur 120 de la figure 2. Ces éléments ne seront pas décrits à nouveau. Le capteur 140 de la figure 4 diffère du capteur 120 de la figure 2 essentiellement en ce que, dans le capteur 140, des cellules élémentaires d'acquisition 141, à la fois thermiques et capacitives, remplacent les cellules thermiques 121 du capteur 120. Les cellules 141 du capteur 140 comprennent les mêmes éléments que les cellules 121 du capteur 120, et diffèrent des cellules 121 en ce qu'elles comportent en outre chacune une électrode conductrice EL connectée au noeud SN, l'électrode EL étant revêtue d'une couche diélectrique et étant destinée à former une capacité avec la peau d'un doigt de l'utilisateur. Les cellules 141 du capteur 140 diffèrent en outre des cellules 121 du capteur 120 en ce que, dans les cellules 141, l'électrode de l'élément pyroélectrique PYR opposée au noeud de lecture SN n'est pas connectée à un noeud d'application d'un potentiel de référence, mais à un noeud CMD d'application d'un signal de commande. L'électrode EL est de préférence placée au voisinage de la surface supérieure du capteur, de façon que l'épaisseur de diélectrique entre la surface supérieure du capteur (destinée à recevoir le doigt de l'utilisateur) et l'électrode EL ne dépasse pas quelques microns, par exemple 50 µm et de préférence 10 µm. En pratique, si l'électrode de l'élément PYR connectée au noeud SN est située au voisinage de la surface du capteur, l'électrode EL peut être confondue avec cette électrode, comme cela est illustré par la figure 5 qui sera décrite ci-après. Les cellules 141 du capteur de la figure 4 ne comportent pas de condensateur de référence spécifiquement dédié à la lecture capacitive, la capacité de référence par l'intermédiaire de laquelle est appliqué le signal de commande lors d'une acquisition capacitive étant celle de l'élément pyroélectrique PYR.

Pour acquérir une image thermique, les noeuds CMD des cellules 141 peuvent être mis à un même potentiel fixe de référence, le fonctionnement du capteur 140 étant alors identique ou similaire au fonctionnement du capteur 120 de la figure 2.

Lors d'une acquisition d'une image capacitive, la source de chaleur du capteur peut être maintenue éteinte, et, dans chaque cellule 141, après réinitialisation du noeud de lecture SN de la cellule via son transistor RT, un signal de commande adapté à la mise en oeuvre d'une lecture capacitive, par exemple une tension en créneau ou en échelon, est appliqué sur le noeud CMD de chaque cellule 141 par un circuit de commande non représenté. La capacité de l'élément PYR et la capacité formée entre l'électrode EL et la peau forment un pont diviseur capacitif, et un potentiel dépendant de la capacité formée entre l'électrode EL et la peau s'établit sur le noeud de lecture de chaque cellule. Le potentiel du noeud SN est reporté sur la piste de sortie CL de la cellule par l'intermédiaire des transistors SF et RD, puis le potentiel de la piste de sortie CL est lu par l'étage de sortie 113 associé à la piste de sortie CL. L'échelon appliqué sur le noeud CMD peut alors être ramené à sa valeur initiale.

A titre d'exemple, lors de l'acquisition d'une empreinte, la séquence de commande suivante peut être mise en oeuvre :
- réinitialisation du noeud de lecture SN par la mise à l'état passant, puis à l'état non passant, du transistor RT (une lecture du niveau de référence du noeud SN peut être réalisée après la réinitialisation) ;
- application d'un signal de commande adapté à la mise en oeuvre d'une lecture capacitive, par exemple un créneau de tension, sur le noeud CMD ;
- lecture capacitive du potentiel du noeud SN en vue de la fourniture d'une image capacitive de l'empreinte ;
- réinitialisation du noeud de lecture SN par la mise à l'état passant, puis à l'état non passant, du transistor RT ;
- allumage de la source de chaleur (à titre de variante, la source de chaleur peut être allumée dès la phase de réinitialisation de la cellule - avant l'ouverture du transistor RT - afin de s'affranchir d'un éventuel bruit parasite lié à des effets transitoires d'appel de courant par la source de chaleur) ; et
- après une période d'intégration, lecture du noeud SN en vue de la fourniture d'une image thermique de l'empreinte.

A titre de variante, l'ordre d'acquisition des images capacitive et thermique peut être inversé.

Outre qu'il permet d'obtenir deux images, respectivement thermique et capacitive, d'une même empreinte, le capteur de la figure 4 présente l'avantage supplémentaire, lorsqu'il fonctionne en mode thermique, de permettre une meilleure discrimination entre les crêtes et les vallées de la peau qu'un capteur du type décrit en relation avec la figure 2. En effet, lors d'une acquisition thermique, la capacité du noeud de lecture SN n'est pas la même dans toutes les cellules du capteur, puisqu'elle inclut la capacité formée entre l'électrode EL et la peau de l'utilisateur, qui varie selon que la cellule est surmontée par une vallée ou par une crête de la peau. Dans le cas où une cellule est surmontée par une vallée de la peau, c'est-à-dire que la peau est relativement éloignée de l'électrode EL, la capacité formée entre l'électrode EL et la peau est plus faible que lorsque la cellule est surmontée par une crête de la peau. Ainsi, la capacité du noeud de lecture SN est plus faible dans une cellule 141 surmontée par une vallée de la peau que dans une cellule surmontée par une crête de la peau. En d'autres termes, le facteur de conversion de charges en tension est plus élevé dans une cellule 141 surmontée par une vallée de la peau que dans une cellule surmontée par une crête de la peau. Or, lors d'une lecture thermique, la quantité de charges générées par l'élément pyroélectrique est plus élevée dans une cellule surmontée par une vallée de la peau que dans une cellule surmontée par une crête de la peau. La présence de l'électrode EL, formant avec la peau de l'utilisateur une capacité qui s'ajoute à la capacité du noeud SN, a ainsi pour effet d'amplifier la différence de potentiel recherchée sur le noeud SN entre les cellules surmontées par une crête et les cellules surmontées par une vallée de la peau.

La figure 5 est une vue en coupe illustrant de façon schématique et partielle un exemple de réalisation (non limitatif) d'une cellule 141 du capteur de la figure 4. Plus particulièrement, la figure 5 représente l'élément pyroélectrique PYR, le noeud SN, l'électrode EL, et le transistor de réinitialisation RT de la cellule. Sur cette figure, les transistors SF et RD de la cellule n'ont pas été représentés.

Dans l'exemple de la figure 5, la cellule 141 est formée sur un substrat diélectrique 501, par exemple en verre. Une couche localisée 503 d'un matériau semiconducteur, par exemple du silicium polycristallin, est disposée au-dessus de la surface supérieure du substrat 501. Le transistor RT, ainsi que les transistors SF et RD (non représentés), sont formés dans et sur la couche semiconductrice 503. En particulier, les régions de source et de drain et les régions de formation de canal des transistors de la cellule sont formées dans la couche 503. Des résistances de chauffage, non représentées, formant la source de chaleur du capteur, peuvent aussi être formées dans la couche 503 (par exemple une résistance par cellule). La grille du transistor RT est formée dans un premier niveau de métallisation M1 surmontant la couche 503 et séparé de la couche 503 par une couche isolante formant l'oxyde de grille du transistor RT. Les électrodes de source et de drain du transistor RT sont formées dans un deuxième niveau de métallisation M2 surmontant le niveau M1. Une première électrode de l'élément pyroélectrique PYR, connectée au noeud de commande CMD, est formée dans un troisième niveau de métallisation M3 surmontant le niveau M2. Cette électrode est revêtue d'une couche 505 d'un matériau pyroélectrique. La couche 505 est revêtue par la deuxième électrode de l'élément pyroélectrique PYR, formée dans un quatrième niveau de métallisation M4. Dans cet exemple, la deuxième électrode (électrode supérieure) de l'élément pyroélectrique PYR est confondue avec l'électrode EL, et est connectée à une électrode de source ou drain du transistor RT (niveau M2) par l'intermédiaire d'un via 507. L'électrode de source ou drain du transistor RT connectée à l'électrode EL définit le noeud de lecture SN de la cellule, et est connectée à la grille du transistor RD (non représenté). Une couche isolante 509 revêt le niveau de métallisation M4. La couche 509 forme le diélectrique de la capacité entre l'électrode EL et la peau de l'utilisateur. La surface supérieure de la couche 509 est destinée à être mise en contact avec la peau dont on souhaite acquérir une empreinte. A titre d'exemple, la couche 509 a une épaisseur inférieure ou égale à 50 µm, et de préférence inférieure ou égale à 10 µm.

La figure 6 est un schéma électrique illustrant un exemple d'un mode de réalisation d'un capteur d'empreintes TFT optique et capacitif 160. Le capteur 160 de la figure 6 comprend des éléments communs avec le capteur 110 de la figure 1. Ces éléments ne seront pas décrits à nouveau. Le capteur 160 de la figure 6 diffère du capteur 110 de la figure 1 essentiellement en ce que, dans le capteur 160, des cellules élémentaires d'acquisition 161, à la fois optiques et capacitives, remplacent les cellules optiques 111 du capteur 110. Les cellules 161 du capteur 160 comprennent les mêmes éléments que les cellules 111 du capteur 110, et diffèrent des cellules 111 en ce qu'elles comportent en outre chacune une électrode conductrice EL connectée au noeud SN, l'électrode EL étant revêtue d'une couche diélectrique et étant destinée à former une capacité avec la peau d'un doigt de l'utilisateur. De plus, les cellules 161 du capteur 160 diffèrent des cellules 111 du capteur 110 en ce que, dans les cellules 161, l'électrode de l'élément photoélectrique PS opposée au noeud de lecture SN (l'anode de la photodiode PS dans l'exemple représenté) n'est pas connectée à un noeud d'application d'un potentiel de référence, mais à un noeud CMD d'application d'un signal de commande. L'électrode EL est de préférence placée au voisinage de la surface supérieure du capteur, de façon que l'épaisseur de diélectrique entre la surface supérieure du capteur (destinée à recevoir le doigt de l'utilisateur) et l'électrode EL ne dépasse pas quelques microns, par exemple 50 µm et de préférence 10 µm. En pratique, si l'électrode de l'élément PS connectée au noeud SN est située au voisinage de la surface du capteur, l'électrode EL peut être confondue avec cette électrode. Les cellules 161 du capteur de la figure 6 ne comportent pas de condensateur de référence spécifiquement dédié à la lecture capacitive, la capacité de référence par l'intermédiaire de laquelle est appliqué le signal de commande lors d'une acquisition capacitive étant celle de l'élément photoélectrique PS.

Pour acquérir une image optique, les noeuds CMD des cellules 161 peuvent être mis à un même potentiel fixe de référence, le fonctionnement du capteur 160 étant alors identique ou similaire au fonctionnement du capteur 110 de la figure 1.

Lors d'une acquisition d'une image capacitive, la source lumineuse du capteur peut être maintenue éteinte, et, dans chaque cellule 161, après réinitialisation du noeud de lecture SN de la cellule via son transistor RT, un signal de commande adapté à la mise en oeuvre d'une lecture capacitive, par exemple une tension en créneau ou en échelon, est appliqué sur le noeud CMD de chaque cellule 161 par un circuit de commande non représenté. La capacité de l'élément PS et la capacité formée entre l'électrode EL et la peau forment un pont diviseur capacitif, et un potentiel dépendant de la capacité formée entre l'électrode EL et la peau s'établit sur le noeud de lecture de chaque cellule. Le potentiel du noeud SN est reporté sur la piste de sortie CL de la cellule par l'intermédiaire des transistors SF et RD, puis le potentiel de la piste de sortie CL est lu par l'étage de sortie 113 associé à la piste de sortie CL. L'échelon appliqué sur le noeud CMD peut alors être ramené à sa valeur initiale.

Outre qu'il permet d'obtenir deux images, respectivement optique et capacitive, d'une même empreinte, le capteur de la figure 6 présente l'avantage supplémentaire, lorsqu'il fonctionne en mode optique et si l'on considère une configuration dans laquelle une cellule revêtue par une vallée de la peau reçoit plus de lumière qu'une cellule revêtue par une crête de la peau, de permettre une meilleure discrimination entre les crêtes et les vallées de la peau qu'un capteur du type décrit en relation avec la figure 1. En effet, lors d'une acquisition optique, la capacité du noeud de lecture SN n'est pas la même dans toutes les cellules du capteur, puisqu'elle inclut la capacité formée entre l'électrode EL et la peau de l'utilisateur, qui varie selon que la cellule est surmontée par une vallée ou par une crête de la peau. Ainsi, comme dans l'exemple de la figure 4, le facteur de conversion de charges en tension est plus élevé dans une cellule 161 surmontée par une vallée de la peau que dans une cellule surmontée par une crête de la peau. Or, lors d'une lecture optique, la quantité de charges générées par l'élément photoélectrique est plus élevée dans une cellule surmontée par une vallée de la peau que dans une cellule surmontée par une crête de la peau. La présence de l'électrode EL, formant avec la peau de l'utilisateur une capacité qui s'ajoute à la capacité du noeud SN, a ainsi pour effet d'amplifier la différence de potentiel recherchée sur le noeud SN entre les cellules surmontées par une crête et les cellules surmontées par une vallée de la peau.

Les figures 7 et 8 illustrent un mode de réalisation d'un capteur d'empreintes TFT optique, thermique et capacitif. Un avantage de ces capteurs est qu'ils permettent de combiner trois images obtenues au moyen d'éléments d'acquisition basés sur trois phénomènes différents, améliorant encore davantage les performances de détection.

La figure 7 est un schéma électrique d'un exemple de réalisation d'un capteur d'empreintes TFT optique, thermique et capacitif 170. Le capteur 170 de la figure 7 comprend des éléments communs avec le capteur 140 de la figure 4. Ces éléments ne seront pas décrits à nouveau. Le capteur 170 de la figure 7 diffère du capteur 140 de la figure 4 essentiellement en ce que, dans le capteur 170, des cellules élémentaires d'acquisition 171, à la fois optiques, thermiques et capacitives, remplacent les cellules thermiques et capacitives 141 du capteur 140. Dans le capteur 170, chaque cellule élémentaire d'acquisition 171 comprend les mêmes éléments qu'une cellule élémentaire d'acquisition 141 du capteur 140, et comprend en outre un élément de conversion photoélectrique PS connecté en parallèle de l'élément pyroélectrique PYR entre les noeuds SN et CMD. L'élément photoélectrique PS est par exemple une photodiode dont l'anode est connectée au noeud CMD et dont la cathode est connectée au noeud SN.

Le capteur 170 comprend en outre, en plus de la source de chaleur (non représentée) destinée à la mise en oeuvre d'une acquisition thermique, une source lumineuse d'éclairage (non représentée) destinée à la mise en oeuvre d'une acquisition optique d'une image. La source lumineuse et la source de chaleur sont par exemple commandables, par l'intermédiaire d'un circuit de contrôle non représenté, pour, lors d'une phase d'acquisition d'une empreinte, être alternativement allumées puis éteintes. Ainsi, lors d'une phase d'acquisition d'une image thermique de l'empreinte, la source lumineuse peut être éteinte, et la source de chaleur allumée. Il en résulte que seul l'élément pyroélectrique PYR est susceptible de générer des charges électriques représentatives du motif de l'empreinte à acquérir. Lors d'une phase d'acquisition d'une image optique de l'empreinte, la source lumineuse peut être allumée et la source de chaleur éteinte. Il en résulte que seul le photodétecteur PS est susceptible de générer des charges électriques représentatives du motif de l'empreinte à acquérir. Lors d'une phase d'acquisition d'une image capacitive, la source de chaleur et la source lumineuse peuvent être éteintes, et le capteur 170 peut être commandé de façon identique ou similaire à ce qui a été décrit en relation avec les figures 4 et 6, la capacité de référence pour la lecture capacitive étant alors celle de l'association en parallèle des éléments PYR et PS.

La figure 8 est un schéma électrique d'un autre exemple de réalisation d'un capteur d'empreintes TFT optique, thermique et capacitif 180. Le capteur 180 de la figure 8 comprend des éléments communs avec le capteur 170 de la figure 7. Ces éléments ne seront pas décrits à nouveau. Le capteur 180 de la figure 8 diffère du capteur 170 de la figure 7 essentiellement en ce que, dans le capteur 180, des cellules élémentaires d'acquisition 181 remplacent les cellules 171 du capteur 170. Les cellules 181 du capteur 180 diffèrent des cellules 171 du capteur 170 en ce que, dans les cellules 181, le photodétecteur PS n'est pas connecté entre les noeuds CMD et SN, mais est connecté entre un noeud GND d'application d'un potentiel de référence (par exemple la masse) et un noeud intermédiaire n, le noeud n étant relié au noeud SN par un transistor de sélection SW. Plus particulièrement, dans cet exemple, le photodétecteur PS est une photodiode dont l'anode est connectée au noeud GND et dont la cathode est connectée au noeud n. L'élément pyroélectrique PYR est quant à lui connecté entre le noeud SN et le noeud CMD.

Dans le capteur 180, les transistors SW permettent, dans chaque cellule élémentaire d'acquisition, d'isoler le photodétecteur PS du reste de la cellule, ce qui offre des possibilités de commande supplémentaires par rapport au capteur 170 de la figure 7. En particulier, dans l'exemple de la figure 8, la source lumineuse peut rester allumée en permanence, et l'on peut prévoir de rendre le transistor SW non passant pendant les phases d'acquisition des images thermiques et capacitives (ceci permet de simplifier la commande de la source lumineuse). De plus, la variante de la figure 8 donne plus de flexibilité quant au dimensionnement des éléments de conversion optique PS et thermique PYR, que dans un capteur du type décrit en relation avec la figure 7. En particulier, dans l'exemple de la figure 8, lors d'une acquisition capacitive, la mise à l'état non passant du transistor SW permet que la capacité du photodétecteur PS ne contribue pas à la capacité du noeud de lecture SN.

A titre de variante, dans l'exemple de la figure 8, le photodétecteur PS et l'élément pyroélectrique PYR peuvent être intervertis, c'est-à-dire que l'élément PYR peut être placé derrière le transistor de sélection SW, entre les noeuds n et GND, le photodétecteur PS étant alors directement connecté aux noeuds SN et CMD. Ce choix peut être effectué en fonction des valeurs respectives des capacités des éléments PYR et PS.

Des modes de réalisation particuliers ont été décrits. Diverses variantes et modifications apparaîtront à l'homme de l'art.

En particulier, diverses variantes et détails de réalisation de capteurs intégrant un élément de conversion photoélectrique et un élément de conversion pyroélectrique dans une même cellule élémentaire sont décrits dans la demande de brevet français N°14/59494 déposée le 3 octobre 2014, dont le contenu est considéré comme faisant partie intégrante de la présente description. L'homme du métier saura combiner les divers modes de réalisation et variantes décrits dans cette demande antérieure, avec les modes de réalisation de la présente demande, pour réaliser un capteur optique, thermique et capacitif, dans lequel l'électrode EL destinée à former une capacité avec la peau est connectée au noeud de lecture SN de la cellule, et dans lequel la capacité de référence pour la lecture capacitive est formée par un élément de conversion pyroélectrique et/ou par un élément de conversion photoélectrique connecté au noeud de lecture SN de la cellule.

En outre, les modes de réalisation décrits ne se limitent pas aux exemples particuliers d'architectures de cellules élémentaires représentés sur les figures. En particulier, les modes de réalisation décrits peuvent être adaptés à des cellules élémentaires comportant un nombre de transistors TFT différent de 3.

De plus, bien que l'on ait décrit ci-dessus uniquement des exemples de capteurs d'empreintes réalisés en technologie TFT, les modes de réalisation décrits ne se limitent pas à ce cas particulier. L'homme de l'art saura adapter les modes de réalisation décrits à d'autres technologies, par exemple à des capteurs d'empreintes réalisés en technologie CMOS sur substrat semiconducteur, par exemple sur substrat silicium monocristallin.

## Revendications

1. Capteur (140 ; 160 ; 170 ; 180) d'empreintes de portions de peau comportant, sur un substrat de support, une pluralité de cellules élémentaires d'acquisition (141 ; 161 ; 171 ; 181), chaque cellule comportant :
un noeud de lecture (SN) ;
un premier élément de conversion photoélectrique (PS) ou pyroélectrique (PYR) ayant une première électrode connectée au noeud de lecture (SN) et une deuxième électrode connectée à un noeud de commande (CMD) de la cellule ; et
une troisième électrode (EL) connectée au noeud de lecture (SN), la troisième électrode (EL) étant revêtue d'une couche diélectrique et étant destinée à former une capacité avec la peau d'un utilisateur,
dans lequel, dans chaque cellule, le noeud de commande (CMD) est adapté à recevoir un signal de commande permettant la mise en oeuvre d'une lecture, sur le noeud de lecture (SN), d'une valeur représentative de la capacité formée entre la troisième électrode (EL) et la peau de l'utilisateur.

2. Capteur (160 ; 170) selon la revendication 1, dans lequel, dans chaque cellule (161 ; 171), le premier élément (PS) est un élément de conversion photoélectrique.

3. Capteur (160 ; 170) selon la revendication 2, dans lequel, dans chaque cellule (161 ; 171), le premier élément (PS) est une photodiode dont l'anode est connectée au noeud de commande (CMD) et dont la cathode est connectée au noeud de lecture (SN).

4. Capteur (170) selon la revendication 2 ou 3, dans lequel chaque cellule (171) comprend en outre un élément de conversion pyroélectrique (PYR) connecté entre le noeud de commande (CMD) et le noeud de lecture (SN), en parallèle du premier élément (PS).

5. Capteur (140 ; 180) selon la revendication 1, dans lequel, dans chaque cellule (141 ; 181), le premier élément (PYR) est un élément de conversion pyroélectrique.

6. Capteur (180) selon la revendication 5, dans lequel chaque cellule (181) comprend en outre un élément de conversion photoélectrique (PS) relié au noeud de lecture (SN) par l'intermédiaire d'un transistor (SW) de sélection.

7. Capteur (140 ; 160 ; 170 ; 180) selon l'une quelconque des revendications 1 à 6, dans lequel ledit signal de commande est un créneau de tension.

8. Capteur (140 ; 160 ; 170 ; 180) selon l'une quelconque des revendications 1 à 7, comprenant en outre une source lumineuse et/ou une source de chaleur.

9. Capteur (140 ; 160 ; 170 ; 180) selon l'une quelconque des revendications 1 à 8, dans lequel, dans chaque cellule (141 ; 161 ; 171 ; 181), le noeud de lecture (SN) est relié à un noeud d'application d'un potentiel de réinitialisation (V_{RT}) par l'intermédiaire d'un transistor de réinitialisation (RT).

10. Capteur (140 ; 160 ; 170 ; 180) selon l'une quelconque des revendications 1 à 9, dans lequel, dans chaque cellule (141 ; 161 ; 171 ; 181), le noeud de lecture (SN) est relié à une piste de sortie (CL) de la cellule par l'intermédiaire d'un transistor (SF) monté en source suiveuse et d'un transistor de lecture (RD).

## Patentansprüche

1. Sensor (140; 160; 170; 180) für Abdrücke von Hautabschnitten, der auf einem Trägersubstrat eine Vielzahl von elementaren Erfassungszellen (141; 161; 171; 181) aufweist, wobei jede Zelle folgendes aufweist:
einen Sensor- oder Abfühlknoten (SN);
ein erstes photoelektrisches (PS) oder pyroelektrisches (PYR) Umwandlungselement mit einer ersten Elektrode, die mit dem Abfühlknoten (SN) und einer zweiten Elektrode, die mit einem Steuerknoten (CMD) der Zelle verbunden ist; und
eine dritte Elektrode (EL), die mit dem Abfühlknoten (SN) verbunden ist, wobei die dritte Elektrode (EL) mit einer dielektrischen Schicht beschichtet ist und dazu bestimmt ist, einen Kondensator mit der Haut eines Benutzers zu bilden,
wobei der Steuerknoten (CMD) in jeder Zelle in der Lage ist, ein Steuersignal zu empfangen, das es ermöglicht, das Auslesen eines Wertes, der für die zwischen der dritten Elektrode (EL) und der Haut des Benutzers gebildete Kapazität repräsentativ ist, aus dem Abfühlknoten (SN) zu implementieren.

2. Sensor (160; 170) nach Anspruch 1, wobei in jeder Zelle (161; 171) das erste Element (PS) ein photoelektrisches Umwandlungselement ist.

3. Sensor (160; 170) nach Anspruch 2, wobei in jeder Zelle (161; 171) das erste Element (PS) eine Fotodiode ist, deren Anode mit dem Steuerknoten (CMD) verbunden ist und deren Kathode mit dem Abfühlknoten (SN) verbunden ist.

4. Sensor (170) nach Anspruch 2 oder 3, wobei jede Zelle (171) ferner ein pyroelektrisches Umwandlungselement (PYR) aufweist, das zwischen dem Steuerknoten (CMD) und dem Abfühlknoten (SN) parallel zum ersten Element (PS) geschaltet ist.

5. Sensor (140; 180) nach Anspruch 1, wobei in jeder Zelle (141; 181) das erste Element (PYR) ein pyroelektrisches Umwandlungselement ist.

6. Sensor (180) nach Anspruch 5, wobei jede Zelle (181) ferner ein photoelektrisches Umwandlungselement (PS) aufweist, das über einen Auswahltransistor (SW) mit dem Abfühlknoten (SN) gekoppelt ist.

7. Sensor (140; 160; 170; 180) nach einem der Ansprüche 1 bis 6, wobei das Steuersignal eine Rechteckspannungswelle ist.

8. Sensor (140; 160; 170; 180) nach einem der Ansprüche 1 bis 7, der ferner eine Lichtquelle und/oder eine Wärmequelle aufweist.

9. Sensor (140; 160; 170; 180) nach einem der Ansprüche 1 bis 8, wobei in jeder Zelle (141; 161; 171; 181) der Abfühlknoten (SN) mit einem Knoten zum Anlegen eines Reset- bzw. Rücksetz-Potentials (V_{RT}) über einen Reset-Transistor (RT) gekoppelt ist.

10. Sensor (140; 160; 170; 180) nach einem der Ansprüche 1 bis 9, wobei in jeder Zelle (141; 161; 171; 181) der Abfühlknoten (SN) mit einer Ausgangsspur (CL) der Zelle über einen Transistor (SF) gekoppelt ist, der als Folgequelle und Auslesetransistor (RD) angeordnet ist.

## Claims

1. A sensor (140; 160; 170; 180) of prints of skin portions comprising, on a support substrate, a plurality of elementary acquisition cells (141; 161; 171; 181), each cell comprising:
a sense node (SN);
a first photoelectric (PS) or pyroelectric (PYR) conversion element having a first electrode connected to the sense node (SN) and a second electrode connected to a control node (CMD) of the cell; and
a third electrode (EL) connected to the sense node (SN), the third electrode (EL) being coated with a dielectric layer and being intended to form a capacitor with a user's skin,
wherein, in each cell, the control node (CMD) is capable of receiving a control signal enabling to implement the reading out, from the sense node (SN), of a value representative of the capacitance formed between the third electrode (EL) and the user's skin.

2. The sensor (160; 170) of claim 1, wherein, in each cell (161; 171), the first element (PS) is a photoelectric conversion element.

3. The sensor (160; 170) of claim 2, wherein, in each cell (161; 171), the first element (PS) is a photodiode having its anode connected to the control node (CMD) and having its cathode connected to the sense node (SN).

4. The sensor (170) of claim 2 or 3, wherein each cell (171) further comprises a pyroelectric conversion element (PYR) connected between the control node (CMD) and the sense node (SN), in parallel with the first element (PS).

5. The sensor (140; 180) of claim 1, wherein, in each cell (141; 181), the first element (PYR) is a pyroelectric conversion element.

6. The sensor (180) of claim 5, wherein each cell (181) further comprises a photoelectric conversion element (PS) coupled to the sense node (SN) via a selection transistor (SW).

7. The sensor (140; 160; 170; 180) of any of claims 1 to 6, wherein said control signal is a square voltage wave.

8. The sensor (140; 160; 170; 180) of any of claims 1 to 7, further comprising a light source and/or a heat source.

9. The sensor (140; 160; 170; 180) of any of claims 1 to 8, wherein, in each cell (141; 161; 171; 181), the sense node (SN) is coupled to a node of application of a reset potential (V_{RT}) via a reset transistor (RT).

10. The sensor (140; 160; 170; 180) of any of claims 1 to 9, wherein, in each cell (141; 161; 171; 181), the sense node (SN) is coupled to an output track (CL) of the cell via a transistor (SF) assembled as a follower source and a readout transistor (RD).
